(19)

**Europäisches Patentamt**
**European Patent Office**
**Office européen des brevets**

(11) **EP 2 579 445 A1**

(12) **EUROPEAN PATENT APPLICATION**

(43) Date of publication:
**10.04.2013 Bulletin 2013/15**

(51) Int Cl.:
*H02N 2/18* (2006.01)      *H03K 17/30* (2006.01)
*G01R 19/00* (2006.01)    *H02M 7/219* (2006.01)
*G01R 19/04* (2006.01)

(21) Application number: **11184378.5**

(22) Date of filing: **07.10.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Fraunhofer-Gesellschaft zur Förderung der
angewandten Forschung e.V.
80686 München (DE)**

(72) Inventors:
• **Mateu Sáez, Maria Loreto
90491 Nuernberg (DE)**

• **Luehmann, Lars
90480 Nuernberg (DE)**
• **Babel, Philipp
90491 Nuernberg (DE)**
• **Pollak, Markus
90491 Nuernberg (DE)**
• **Spies, Peter
91074 Herzogenaurach (DE)**

(74) Representative: **Zimmermann, Tankred Klaus et al
Patentanwälte Schoppe, Zimmermann,
Stöckeler, Zinkler & Partner
Postfach 246
82043 Pullach (DE)**

(54) **Peak detector for switched ac/dc converter**

(57)    A peak detector (900) for a synchronized switch harvesting on inductor converter comprises a comparator (930) and a filter (905) configured to filter an input signal to the peak detector and to provide a filtered signal to an input of the comparator (930). The filter (905) has a differentiating transfer characteristic for a low frequency range and an integrating transfer characteristic for a high frequency range of the input signal so that peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal. The relatively strong variation of the filtered signal crosses a comparator threshold of the comparator (930). The comparator (930) is configured to generate an output signal that indicates a relation of the filtered signal with respect to the comparator threshold.

FIG 9

**Description**

Embodiments of the present invention relate to a peak detector, in particular a peak detector for an alternating-current/direct-current (AC/DC) converter, such as a synchronized switch harvesting on inductor (SSHI) converter. Some embodiments relate to a converter for converting alternating current to direct current. Some embodiments relate to a method for detecting a peak in an electrical input voltage for an alternating-current/direct-current converter. Some embodiments relate to a method for generating a control signal for at least one controllable switching element of an alternating-current/direct-current converter.

Energy harvesting (also known as power harvesting or energy scavenging) is a process by which energy is derived from external sources (e.g., solar power, thermal energy, wind energy, salinity gradients, and kinetic energy), captured, and stored for small, wireless autonomous devices, like those used in wearable electronics and wireless sensor networks. For example, piezoelectric transducers are employed for harvesting electrical power from vibrations. Different AC-DC converters are described in the literature in order to rectify the AC power and extract the maximum amount of energy.

Possible applications of energy harvesters comprising such AC-DC converters for piezoelectric generators are, e.g., in applications like highway bridges (structural health monitoring) or railway trains (tracking and tracing). The frequency range of the vibrations associated to these applications is between 2 and 20 Hz, whereas mean accelerations are around 0.1 g.

When a piezoelectric material is mechanically excited, it transforms the mechanical energy into electrical energy. The AC power available between its electrical terminals has to be rectified to obtain DC power. A control circuit allows switching the transistors of a non-linear rectifier technique (SSHI) that provides better results than a diode bridge rectifier.

When a piezoelectric element is in open circuit, the derivative of its voltage and the derivative of its displacement are proportional since I=0.

$$I = \alpha \, du/dt - C_0 \, dv_1/dt \, ,$$

where I is the current flowing out of the piezoelectric element, u is the piezoelectric displacement, $V_1$ is the piezoelectric voltage, $\alpha$ is the force factor and $C_0$ is the capacitance of the piezoelectric element (cf. S. Priya and D.J. Inman, Energy Harvesting Technologies, Springer, 2009, pp. 209-259).

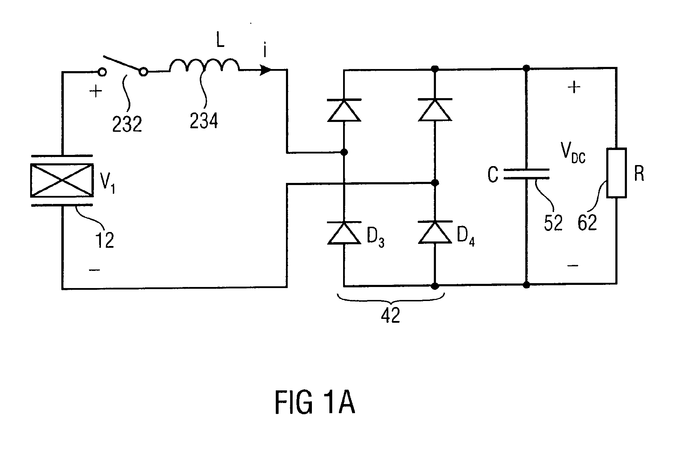

The series SSHI converter (Fig. 1A) remains in open circuit almost all the time and the switch that connects the piezoelectric element to the inductor, the diode bridge and the load is closed just for a short time. For this converter, it can be considered that when there is a piezoelectric voltage peak, there is also a peak displacement of the piezoelectric element. In this way, the power harvested from the piezoelectric element is maximum. Therefore, a voltage peak detector circuit is the appropriate control circuit for the series SSHI converter in order to maximize the harvested power.

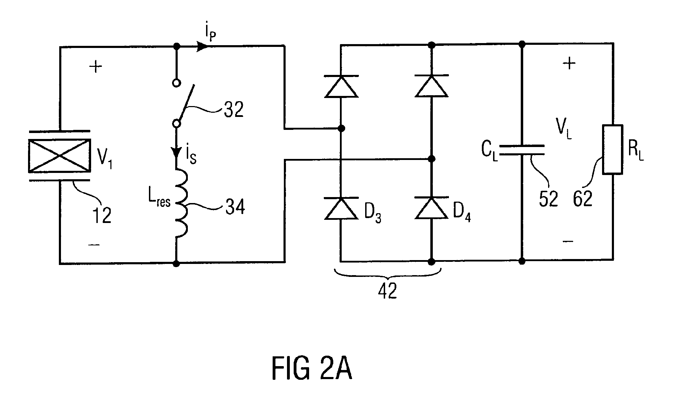

For the parallel SSHI converter, (Fig. 2A), the piezoelectric element is continuously connected to the rectifier bridge and the output load which creates a phase shift between the derivatives of the displacement and the voltage of the piezoelectric element, and therefore a peak voltage detector circuit cannot detect the peak displacement without error.

A voltage peak detector circuit is one of several typically employed control circuit for switching the transistors of the SSHI converters.

The AC power delivered by piezoelectric transducers is usually rectified employing a diode bridge and a filtering capacitor. Recently, an AC-DC converter which employs an inductor connected through a switch to the piezoelectric element has been proposed. The switch is closed when the piezoelectric voltage peak is reached. In this moment, the connection of the piezoelectric element with the inductor causes a resonant effect and a fast inversion of the piezoelectric voltage. After the piezoelectric voltage inversion, the switch is opened until a new peak is detected.

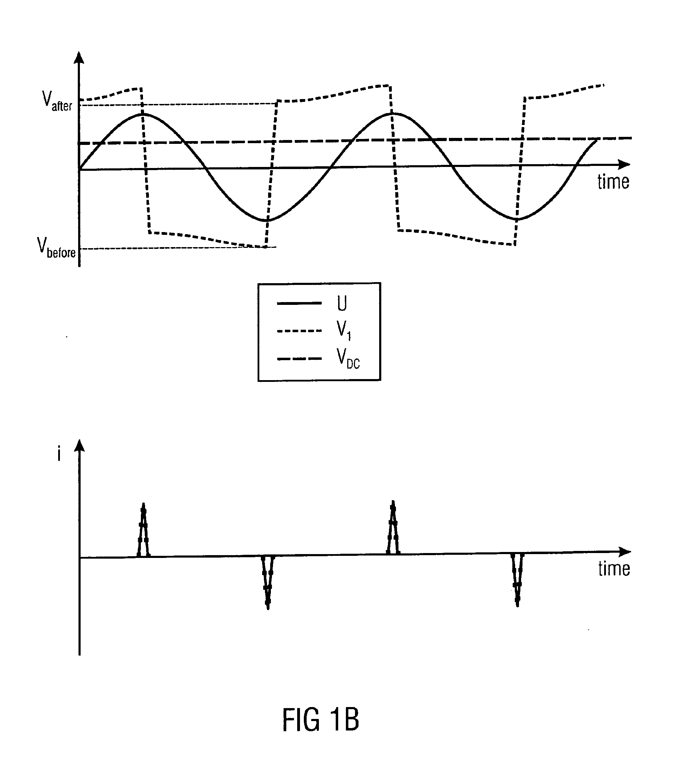

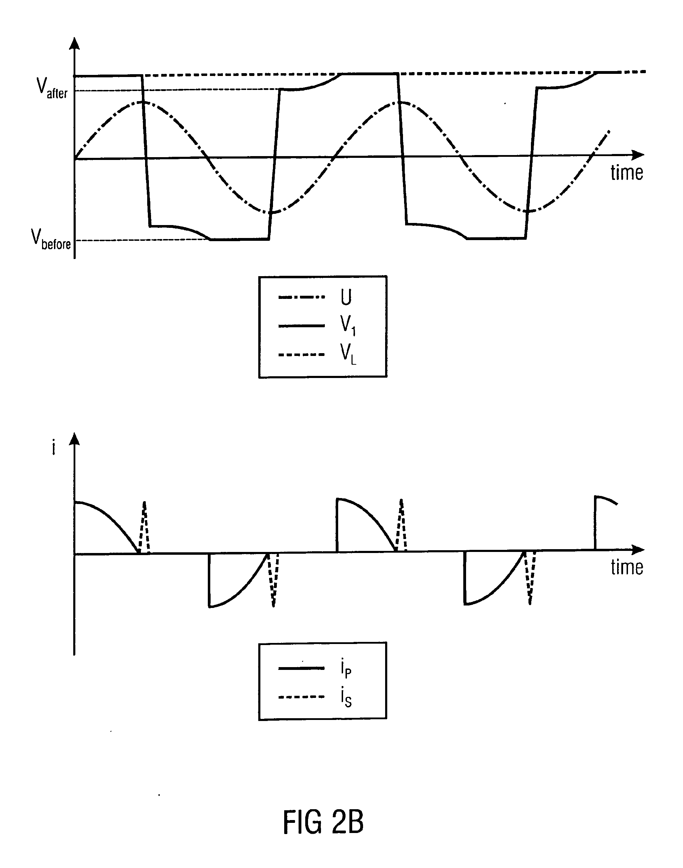

There are two SSHI techniques: parallel and series. In the series SSHI circuit shown in Fig. 1, the inductor and the switch are connected in series between the piezoelectric element and the diode bridge and the filter capacitor. In the case of the parallel SSHI technique shown in Fig. 2, the switch and the inductor are connected in parallel to the piezoelectric element and the diode bridge and the filter capacitor are connected afterwards.

Commonly used control circuits for the switching transistors of the SSHI circuits use the piezoelectric voltage as input signal. These control circuits employ a peak detector and a comparator for generating the gate signal. The peak detector changes its polarity when the piezoelectric voltage has reached a peak and the comparator provides the positive and negative voltage levels for switching the transistors.

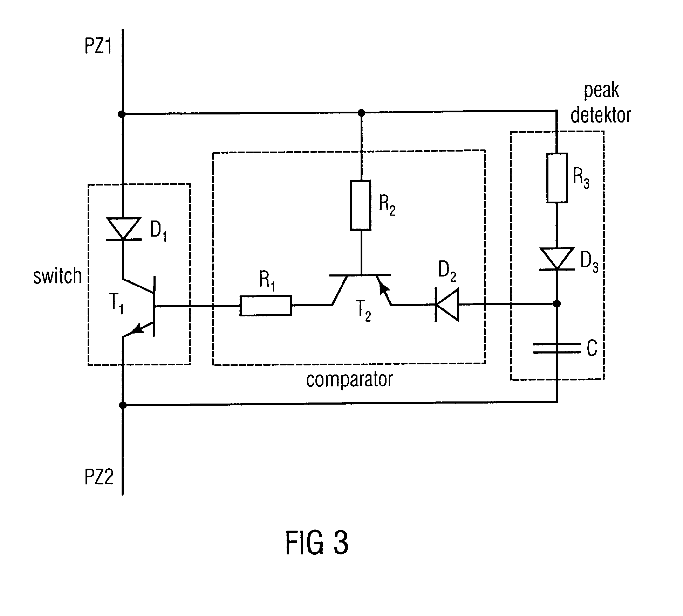

The implementation of the self-powered control circuit is done in the literature employing primarily two different circuits. Fig. 3 shows a solution for detecting positive peaks which is described by M. Lallart and D. Guyomar in "An optimized self-powered switching circuit for non-linear energy harvesting with low voltage output," Smart Materials and Structures, Vol. 17, No. 3, 2008 and also in an international patent application PCT/FR2005/003000 (publication number:

WO/2007/063194) by C. Richard, D. Guyomar and E. Lefeuvre entitled "Self-powered electronic breaker with automatic switching by detecting maxima or minima of potential difference between its power electrodes". The peak detector circuit is composed by resistor $R_3$, diode $D_3$ and capacitor C. The direction of the diode assures that only positive peaks are detected. This peak detector circuit is a differentiator. When the voltage on the emitter of transistor $T_2$ is higher than the voltage on the base, transistor $T_2$ starts conducting and diode $D_3$ is reverse biased since the voltage on the capacitor is bigger than the piezoelectric voltage. Since the base voltage of transistor $T_1$ is higher than its emitter voltage, transistor $T_1$ starts conducting and capacitor C is discharged. A complementary control circuit with a switch is required for detecting the negative peaks of the piezoelectric element.

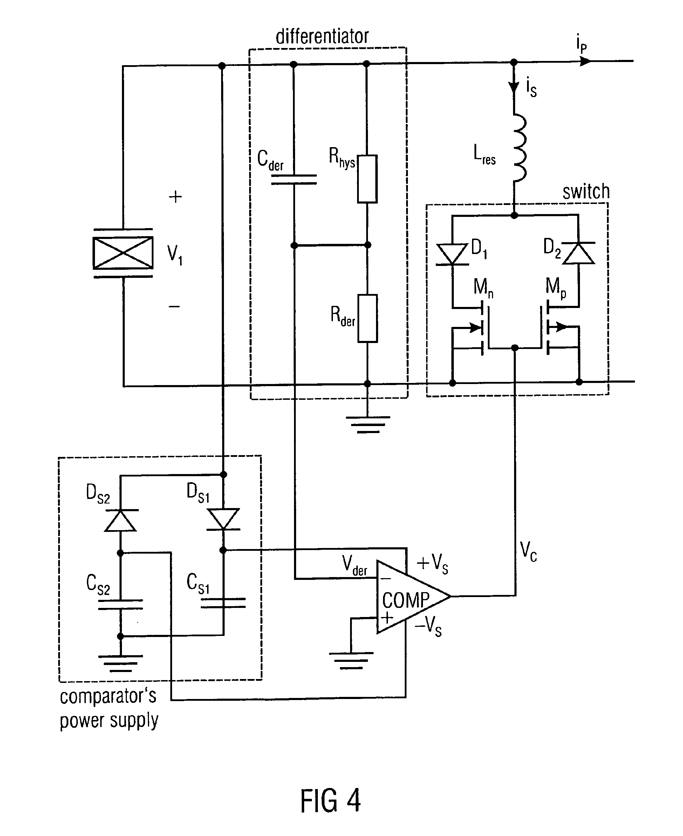

Another solution available in the literature consists of a passive differentiator with hysteresis and a discrete comparator (see Fig. 4) which is described in S. Ben-Yaakov and N. Krihely, "Resonant rectifier for piezoelectric sources", Applied Power Electronics Conference and Exposition, 2005, APEC 2005, Twentieth Annual IEEE, vol.1, pp.249-253, 6-10 March 2005. The passive differentiator detects when there is a voltage peak changing the polarity of its output. The output of the passive differentiator is connected to the negative input of the comparator whereas the positive input is connected to the piezoelectric reference terminal. The output of the comparator is connected to the gate of the transistors for switching them appropriately. The authors claim that the differentiator with hysteresis prevents undesired triggers through $R_{hys}$. The transfer function of a differentiator composed by a capacitor $C_{der}$ and a resistor $R_{der}$ is:

$$\frac{V_{out}}{V_{in}} = \frac{s}{s + \frac{1}{R_{der} C_{der}}}$$

If a resistor $R_{hys}$ is connected in parallel to capacitor $C_{der}$, the transfer function of this circuit is given by:

$$\frac{V_{out}}{V_{in}} = \frac{s + \frac{1}{R_{hys} C_{der}}}{s + \frac{R_{der} + R_{hys}}{R_{der} R_{hys} C_{der}}}$$

This transfer function has a zero located at $\omega_z = 1/(R_{hys}C_{der})$ and a pole located at $\omega_p = (R_{der} + R_{hys}) / (R_{der}R_{hys}C_{der})$. For a proper operation of the circuit as a differentiator, $\omega_z$ must be smaller than $\omega_p$. This circuit will act as a differentiator for angular frequencies which fulfill that $10\omega_z < \omega < 0.1 \omega_p$.

The previous solution employs the same control circuit for detecting positive and negative voltage peaks.

If the piezoelectric voltage inversion does not take place when there is a peak displacement, there are two possibilities: the piezoelectric voltage inversion has been taken place before or after the peak displacement.

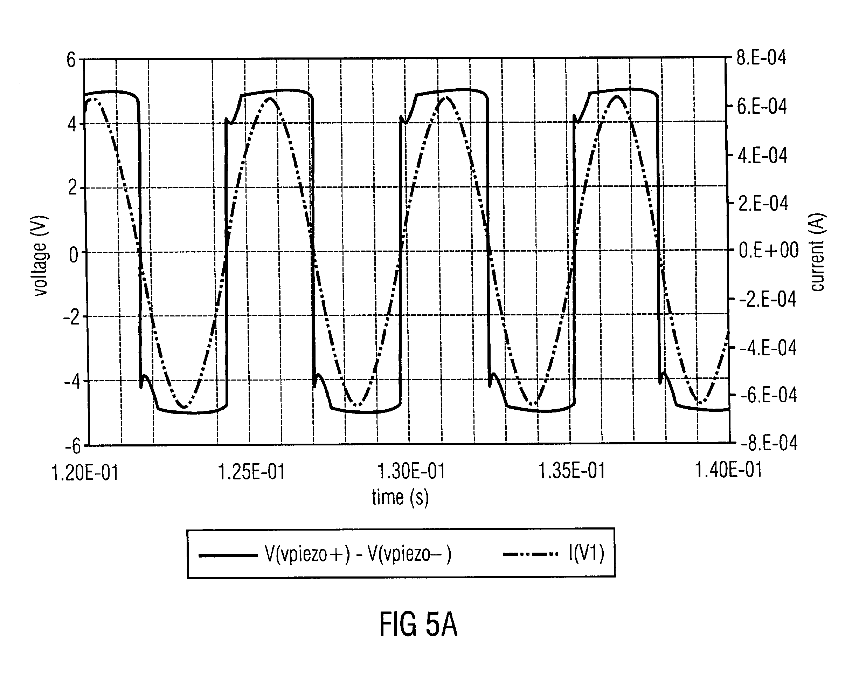

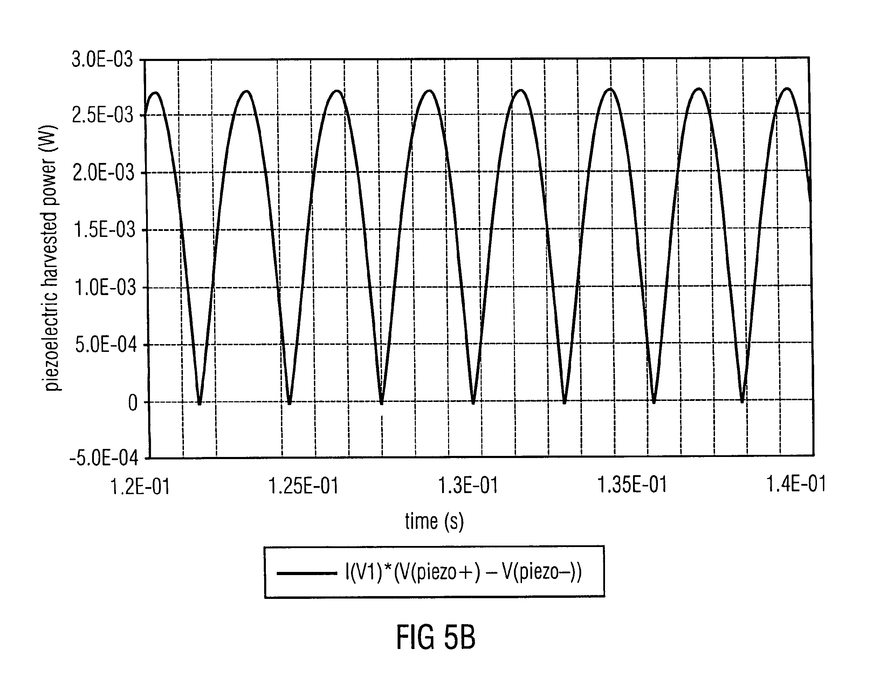

If the piezoelectric voltage inversion takes place at the peak displacement, piezoelectric voltage and current have the same polarity and the power harvested by the piezoelectric element is maximum (see Figs. 5A and 5B). However, since the piezoelectric element typically is not in open circuit, the piezoelectric voltage typically does not correspond at all with the peak displacement.

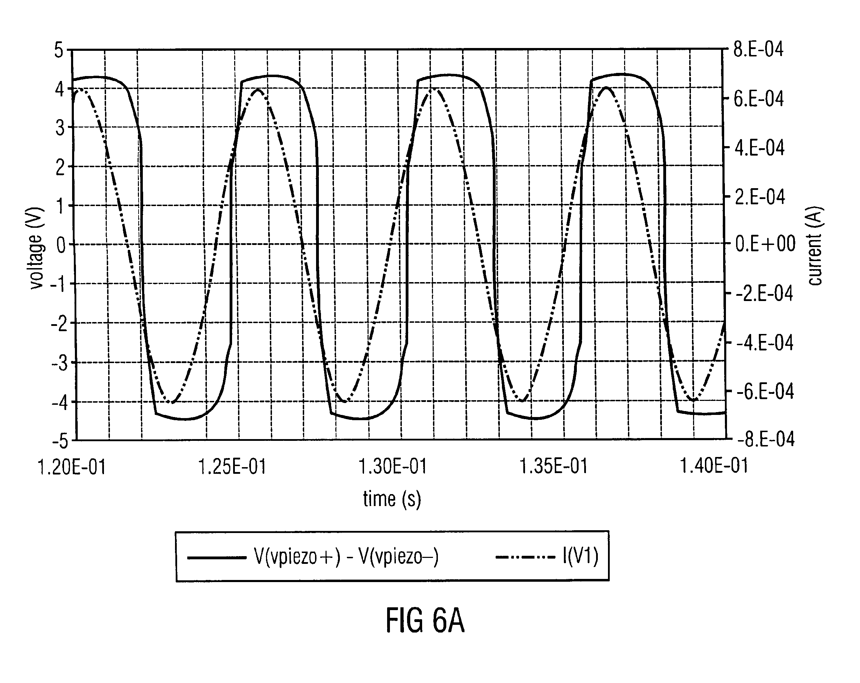

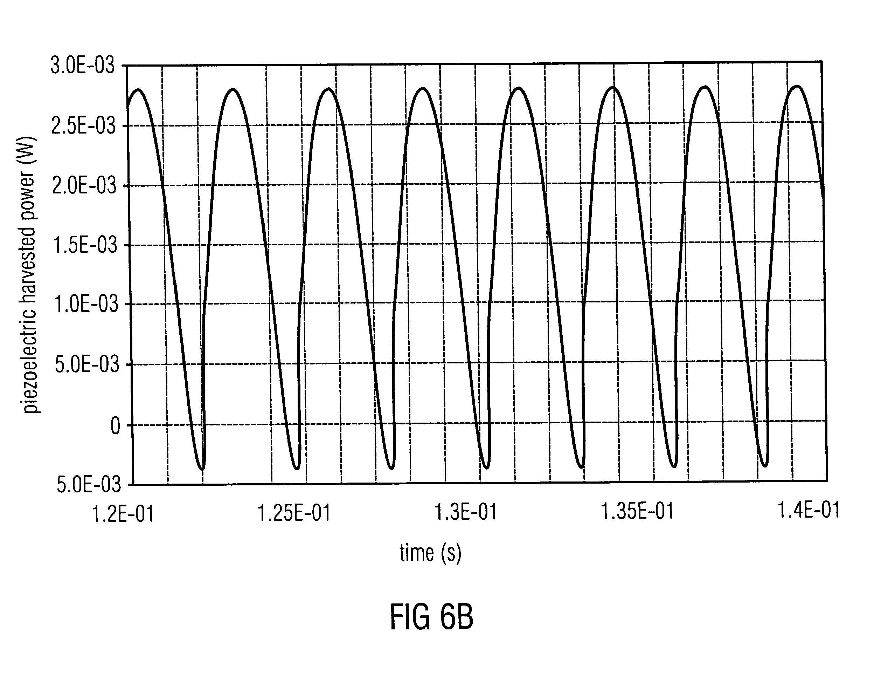

If the piezoelectric voltage inversion is done after the peak displacement, there is a time period before the piezoelectric voltage inversion where the piezoelectric voltage and current do not have the same polarity, and therefore the power harvested by the piezoelectric element is not maximized. However, the state-of-the-art peak detectors do not produce false peak detection under this circumstance. Figs. 6A and 6B show a simulation example where the piezoelectric voltage inversion takes place after the peak displacement.

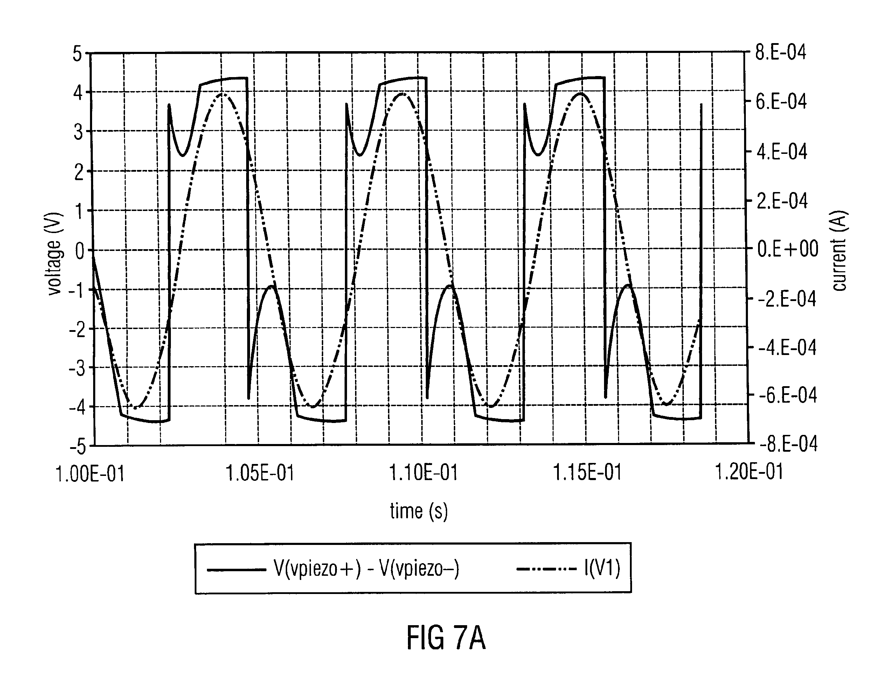

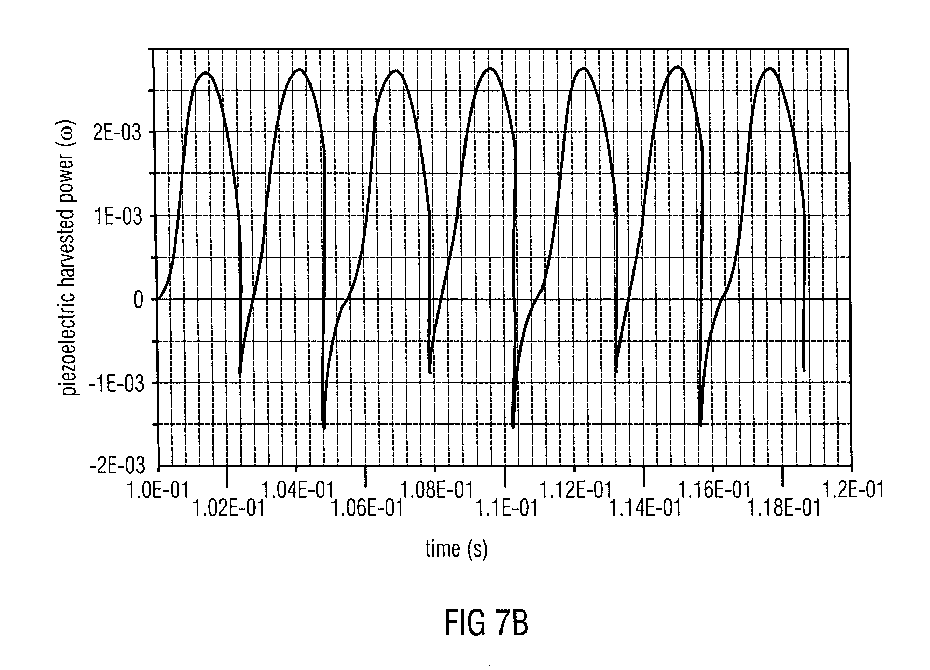

If the piezoelectric voltage inversion is done before the peak displacement, it means that the internal piezoelectric current source has the opposite polarity of the piezoelectric voltage and as long as this situation takes place, the internal capacitor of the piezoelectric element is discharged. This circumstance causes that the state-of-the art differentiators to detect a false peak. Figs. 7A and 7B present a simulation that illustrates this scenario.

When the piezoelectric voltage inverses its polarity, an overshoot may occur, which may be caused by the resonant circuit. The overshoot is a local maximum or minimum so that commonly used peak detectors may indicate the occurrence of a peak due to the overshoot. However, such a local maximum/minimum caused by such an overshoot immediately following a commutation of the piezoelectric voltage is typically not significant for an upcoming switching event to be performed by the switch. Therefore, a detection of such an overshoot as a switching-event-relevant peak is a false detection which is prone to disturb the operation of the AC/DC converter, thereby possibly reducing the harvested power.

Therefore, it is the object of the present invention to provide a peak detector which has a higher selectivity with respect to the peaks to be detected, for example, a higher rejection to false peak detections than the state-of-the-art peak detectors when the piezoelectric voltage inversion is done before the peak displacement.

This object is solved by a peak detector for a synchronized harvesting on inductor converter according to claim 1, a converter for converting alternating current to direct current according to claim 13, a method for detecting a peak in an electrical input voltage for an alternating-current/direct-current converter according to claim 14, and a method for generating a control signal for at least one controllable switching element of an alternating-current/direct-current converter according to claim 15.

Embodiments of the present invention provide a peak detector for a synchronized switch harvesting on inductor converter. The peak detector comprises a comparator and a filter configured to filter an input signal to the peak detector and to provide a filtered signal to an input of the comparator. The filter has a differentiating transfer characteristic for a low frequency range and an integrating transfer characteristic for a high frequency range of the input signal so that peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal. The relatively strong variation of the filtered signal crosses a comparator threshold of the comparator and the comparator is configured to generate an output signal that indicates a relation of the filtered signal with respect to the comparator threshold.

The peak detection according to the teachings disclosed herein exploits the fact that switching-event-relevant peaks in the piezoelectric voltage have different spectral properties than spurious peaks, such as overshoots caused by a preceding commutation or inversion of the piezoelectric voltage. In this manner, a higher reliability of the detection of switching-event-relevant peaks can be achieved and the detected switching-event-relevant peaks are then processed, evaluated, and/or used to generate a control signal for controllable switching elements of an SSHI converter that is connected to the peak detector. In particular, the spectral properties of the switching-event-relevant peaks are rather in a relatively lower frequency range while the spectral properties of the spurious peaks are rather in a relatively higher frequency range. The filter of the peak detector has a bandpass-like characteristic without necessarily being a "classical" bandpass filter.

According to further embodiments of the teachings disclosed herein, a magnitude transfer function of the filter may have a maximum at a frequency between the low frequency range and the high frequency range.

A maximum magnitude frequency of a transfer function of the filter may be between 80Hz and 400Hz, preferably between 100Hz and 350Hz, more preferably between 110Hz and 300Hz, for example 120Hz, 140Hz, 160Hz, 200Hz, 240Hz, 260Hz, and/or 280Hz, as well as values in between. In terms of angular frequency, the maximum magnitude angular frequency may be between 500 rad/s and 3000 rad/s, preferably between 700 rad/s and 2000 rad/s, more preferably between 800 rad/s and 1500 rad/s.

According to further embodiments, the filter may comprise a first filter branch connected between a first peak detector input terminal and a comparator input terminal, and a second filter branch connected between a second peak detector input terminal and the comparator input terminal, wherein at least one of the first filter branch and the second filter branch comprises an energy storing element.

The filter may comprise a voltage divider configured to divide an input voltage corresponding to the input signal and to provide a divisional voltage at an intermediary node on the basis of which the filtered signal is determined.

According to further embodiments, the filter may comprise at least one linear component and at least one non-linear component. The linear component may be, for example, a resistor, a capacitor, or a combination of both. The non-linear component may be, for example, a diode or a combination of two or more diodes.

According to further embodiments the filter may comprise an energy storing circuit and a clipper circuit. The energy storing circuit may connect a first input of the peak detector to a first input of the comparator and exhibit an energy storing behavior. The clipper circuit may connect a second input of the peak detector to the first input of the comparator. The clipper circuit may be configured to maintain a clipper circuit voltage across the clipper circuit within a voltage range defined by at least one clipping threshold. Moreover, the clipper circuit may be configured to maintain the clipper circuit voltage at the clipping threshold while an input voltage between the first input and the second input of the peak detector is monotone and outside the voltage range. A comparator input voltage between the first input of the comparator and a second input of the comparator may be based on the clipper circuit voltage. A comparator threshold voltage of the comparator is within the voltage range. The energy storing circuit may be configured, due to the energy storing behavior, to push the clipper circuit voltage across the clipping threshold into the voltage range and thereby causes the comparator input voltage to cross the comparator threshold in response to a peak in the input voltage so that an output of the comparator indicates the peak as a signal edge.

The energy storing circuit may comprise a capacitor and a resistor, the capacitor being configured to provide the energy storing behavior by storing an electrical charge.

According to further embodiment of the teachings disclosed herein, a capacitor voltage across the capacitor may change relatively slowly in response to a peak so that the voltage at the first input of the comparator substantially follows the peak which causes the clipper circuit voltage to be pushed away from the clipping threshold into the voltage range of the clipper circuit. In this situation, the capacitor acts as a relatively inert circuit component which opposes a rapid variation of the capacitor voltage. Accordingly, an electrical potential at the node between the capacitor and the clipper circuit is varied in the manner described above. This action may cause the clipper circuit to enter a blocking state in which it does not conduct an electrical current. Accordingly, the capacitor cannot be discharged via the clipper circuit and is bound to maintain approximately the capacitor voltage which it had when the peak occurred. This leads to a rapid variation of the electrical potential at the node between the energy storing circuit and the clipper circuit and hence to a crossing (i.e., exceeding or deceeding) the comparator threshold.

The clipper circuit may be configured to be in a blocking state when the clipper circuit voltage is not at the clipping voltage and to be in a non-blocking state when the clipper circuit voltage is at or beyond the clipping voltage.

The clipper circuit may comprise two antiparallel diodes or two antiparallel elements with diode-like characteristic.

According to further embodiments, the clipping threshold may be an upper clipping threshold and the voltage range may be further defined by a lower clipping threshold. The clipper circuit may be configured to maintain the clipper circuit voltage at the lower clipping threshold when the input voltage between the first input and the second input of the peak detector is below the lower threshold and monotonously diverging from the lower threshold. Likewise, the clipper circuit may further be configured to maintain the clipper circuit voltage at the upper clipping threshold when the input voltage between the first input and the second input of the peak detector is above the upper threshold and monotonously diverging from the upper threshold.

Further embodiments provide a converter for converting alternating current to direct current, the converter comprising a peak detector as herein described.

A method for detecting a peak in an electrical input voltage for an alternating-current/direct-current converter according to the teachings disclosed herein comprises receiving an input signal for a peak detector and filtering the input signal with a filter. The filter has a differentiating transfer characteristic for a low frequency range and an integrating transfer characteristic for a high frequency range of the input signal. By filtering the input signal a filtered signal is obtained. Peaks of the input signal to the peak detector which have primarily frequency components in the low frequency range cause a relatively strong variation of the filtered signal and peaks of the input signal to the peak detector which have primarily frequency components in the high frequency range are substantially integrated and therefore cause a relatively weak variation of the filtered signal. The method further comprises comparing the filtered signal with a comparator threshold and generating an output signal on the basis of a result of comparing the filtered signal with the comparator threshold, the output signal indicating a relation of the filtered signal with respect to the comparator threshold.

A method for generating a control signal for at least one controllable switching element of an alternating-current/ direct-current converter according to the teachings disclosed herein comprises detecting a peak in an electrical input voltage for the alternating-current/direct-current converter according to the method for detecting a peak mentioned above, and generating the control signal on the basis of the output signal of the method for detecting the peak.

Embodiments of the present invention are described herein making reference to the appended drawings.

Fig. 1A     shows a schematic circuit diagram of a series SSHI converter according to the prior art.

Fig. 1B     is a graph illustrating various voltage waveforms and electrical current waveforms occurring during the operation of the circuit shown in Fig. 1A.

Fig. 2A     shows a schematic circuit diagram of a parallel SSHI converter according to the prior art.

Fig. 2B     is a graph illustrating various voltage waveforms and electrical current waveforms occurring during the operation of the circuit shown in Fig. 2A.

Fig. 3     shows a schematic circuit diagram of a positive peak detector circuit with switch.

Fig. 4     shows a schematic circuit diagram of a self-powered peak detector circuit for positive and negative peaks.

Fig. 5A     illustrates piezoelectric voltage and current waveforms that are substantially in phase.

Fig. 5B     illustrates the power harvested by a piezoelectric element over time when piezoelectric voltage and current are in phase, as in Fig. 5A.

Fig. 6A    illustrates piezoelectric voltage and current waveforms when the piezoelectric voltage inversion is done after the peak displacement of the piezoelectric element takes place.

Fig. 6B    illustrates the power harvested by the piezoelectric element whose voltage and current waveforms are shown in Fig. 6A.

Fig. 7A    illustrates piezoelectric voltage and current waveforms when the piezoelectric voltage inversion is done before the peak displacement of the piezoelectric element takes place.

Fig. 7B    illustrates the power harvested by the piezoelectric element whose voltage and current waveforms are shown in Fig. 7A.

Fig. 8     illustrates piezoelectric voltage and current waveforms when the piezoelectric voltage inversion is done before the peak displacement of the piezoelectric element takes place and this fact causes more than one peak detection per semi-cycle.

Fig. 9     shows a schematic circuit diagram of a peak detector according to the teachings disclosed herein.

Fig. 10    illustrates Bode plots of three different peak detector circuits.

Fig. 11    illustrates steady state waveforms of voltages occurring in a modified parallel SSHI converter comprising a peak detector according to the teachings disclosed herein.

Equal or equivalent elements or elements with equal or equivalent functionality are denoted in the following description by equal or equivalent reference numerals.

In the following description, a plurality of details are set forth to provide a more thorough explanation of embodiments of the present invention. However, it will be apparent to one skilled in the art that embodiments of the present invention may be practiced without these specific details. In other instances, well-known structures and devices are shown in block diagram form rather than in detail in order to avoid obscuring embodiments of the present invention. In addition, features of the different embodiments described hereinafter may be combined with each other, unless specifically noted otherwise.

The Synchronized Switch Harvesting on Inductor (SSHI) is a non-linear switching technique that provides DC (direct current) power from an energy source, such as a mechanically excited piezoelectric element. A SSHI converter typically consists of a switch and an inductor plus a diode bridge. The switch connects the piezoelectric element to the inductor to form a resonant circuit and invert the piezoelectric voltage. The mechanically excited piezoelectric element typically produces an alternating electric voltage and an alternating current (AC). A control circuit is typically needed for commutating appropriately the switch when a piezoelectric peak voltage is detected.

In the series SSHI circuit, which is illustrated in Fig. 1A, an inductor 234 and a switch 232 are connected in series to a piezoelectric element 12, a diode bridge 42, and a filter capacitor 52. As can be seen in Fig. 1B, in the case of the series SSHI circuit there is no current i flowing from the piezoelectric element 12 to the load 62 except when the switch 232 is closed, as stated in "Energy Harvesting from Ambient Vibrations and Heat", by D. Guyomar, G. Sebald, S. Pruvost, M. Lallart, A. Khodayari and C. Richard, Journal of Intelligent Material Systems and Structures, vol. 20, no. 5, pp. 609-624, March 2009. While the switch 232 is open, the derivative of the piezoelectric voltage and displacement are proportional and the piezoelectric internal capacitor is charged. Once the piezoelectric displacement u reaches an extreme, the switch 232 is closed and the current i flows from the piezoelectric element 12 to the output load 62 through the inductor 234 and the diode bridge 42. Since the series connection of the inductor with the piezoelectric element creates a resonating circuit, the piezoelectric voltage is inverted. Afterwards, the switch is opened again. Prior to opening the switch 232 the piezoelectric voltage $v_1$ has a magnitude of $V_{before}$ and subsequent to closing the switch 232 (and accordingly subsequent to the inversion of the piezoelectric voltage $v_1$ and a phase during which the current i flows) the piezoelectric voltage has a magnitude of $V_{after}$, with $|V_{before}| > |V_{after}|$. The output voltage $V_{DC}$ at the filter capacitor is also illustrated in Fig. 1B.

In the case of the parallel SSHI technique, shown in Fig. 2A, a switch 32 and an inductor 34 are connected in parallel to a piezoelectric element 12. A diode bridge 42, a filter capacitor 52, and the output load 62 are connected afterwards. The parallel SSHI technique is, for example, described in an article by S. Ben-Yaakov and N. Krihely, "Resonant rectifier for piezoelectric sources", Applied Power Electronics Conference and Exposition, 2005. APEC 2005, pp.249-253 Vol. 1, 6-10 March 2005.

The working principle of the parallel SSHI circuit can be explained using Fig. 2B which shows waveforms at steady state associated to the circuit shown in Fig. 2A. The upper diagram in Fig. 2B shows a piezoelectric displacement u, a piezoelectric voltage $v_1$, and a load voltage $V_L$. When a piezoelectric material is mechanically excited, it transforms the mechanical energy into electrical energy. The AC power available between its electrical terminals has to be rectified to obtain DC power. When a piezoelectric element is in open circuit, the derivative of its voltage $dv_1/dt$ and the derivative of its displacement $du/dt$ are proportional since no electrical current is flowing, i.e. I=0.

While the piezoelectric voltage $v_1$ is lower than the rectified voltage, there is no current $i_P$ flowing from the piezoelectric element 12 to the diode bridge 42. Therefore, the derivative of the piezoelectric voltage $dv_1/dt$ and the derivative of the displacement $du/dt$ are proportional. Once the piezoelectric voltage $v_1$ is higher than the rectified voltage plus two times the voltage drop of the diodes, there is current $i_P$ flowing from the piezoelectric element 12 to the diode bridge 42. When the piezoelectric voltage $v_1$ reaches a peak (positive or negative), the switch 32 is closed and current $i_S$ flows from the internal piezoelectric capacitor to the inductor 34. At this moment, a resonant LC circuit is created with the piezoelectric internal capacitor and the voltage on the piezoelectric element changes its polarity in a time $\pi\sqrt{(LC)}$. The current generated by the piezoelectric element flows through the rectifier capacitor 52 and the load 62 when the switch 32 is open and the absolute value of the piezoelectric voltage is higher than the rectified voltage on the load (plus the voltage gaps of two diodes). When the piezoelectric voltage reaches a maximum, the switch 32 is closed. Once the piezoelectric voltage is inverted, the switch 32 is opened again. Since the piezoelectric element 12 is connected most of the time by the diode bridge 42 to the output load 62, it cannot be assumed that when the piezoelectric voltage $v_1$ reaches a peak, the displacement u of the piezoelectric element 12 is maximal. A corresponding parallel SSHI circuit is described by S. Priya and D.J. Inman in "Energy Harvesting Technologies", Springer, 2009, pp.211-213.

If the piezoelectric voltage and current have the same polarity, the power harvested by the piezoelectric element 12, and therefore the power delivered to the output load 62, is higher than if piezoelectric voltage and current have a phase shift. The fact that piezoelectric voltage and current are in-phase makes possible to emulate the complex conjugate of the piezoelectric impedance as output load.

The piezoelectric current source is proportional to the derivative of the piezoelectric displacement. Moreover, when the piezoelectric element 12 is in open circuit, the piezoelectric current source is proportional to the derivative of the piezoelectric voltage. In other words, the multiplication of current and voltage is positive since the SSHI converters invert the piezoelectric voltage through inductor L and this maximizes the output power. Therefore, the piezoelectric voltage and displacement derivatives are proportional (the slopes of both curves have the same sign). However when the piezoelectric power is rectified employing the parallel SSHI circuit, most of the time the piezoelectric element is connected to the output load, and therefore the derivative of the piezoelectric voltage and the derivative of the displacement are not anymore proportional. Thus, it cannot be assured that the zero-crossing of the piezoelectric current source occurs at the piezoelectric voltage peak which maximizes the harvested power. Nevertheless, for the case of the series SSHI, the piezoelectric element is almost always in open circuit and this fact causes the zero-crossing of the internal piezoelectric source to occur during the piezoelectric voltage inversion and the multiplication of piezoelectric voltage and current to be positive, increasing the harvested power.

Fig. 3 shows a schematic circuit diagram of a positive peak detector circuit with switch according to the prior art. Fig. 4 shows a schematic circuit diagram of another self-powered peak detector circuit for positive and negative peaks according to the prior art. The mode of operation of the peak detectors shown in Figs. 3 and 4 is described above in the introduction.

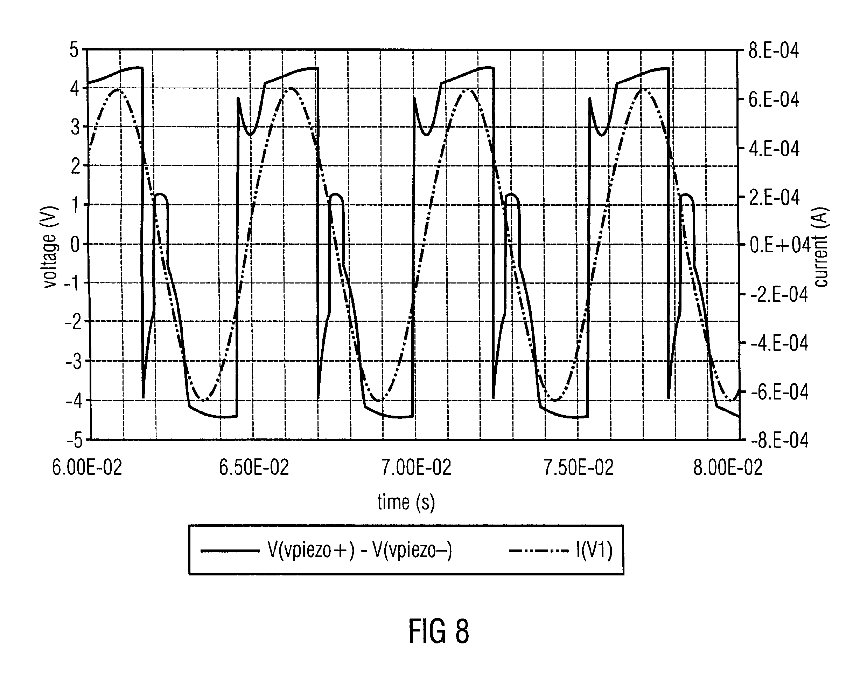

Figs. 5A, 6A, 7A, and 8 illustrate typical waveforms of the piezoelectric voltage $v_1$ which is expressed in Figs. 5A, 6A, 7A, and 8 as V(vpiezo+) - V(vpiezo-). In Figs. 5A, 7A, and 8 it can be observed that the piezoelectric voltage overshoots more or less when changing its polarity. These overshoots may cause false peak detections of the peak detectors according to the prior art depicted in Figs. 3 and 4. Fig. 8 shows the simulation waveforms of the piezoelectric voltage and current that illustrates the case of false voltage peak detection. Furthermore, Fig. 8 illustrates how such a false peak detection may cause the AC/DC converter to perform one or even two additional switching events. It can be seen that after a transition from positive to negative the piezoelectric voltage bounces back up from a value of approximately -4V to a value of approximately -2V. The peak at -4V is falsely detected by the prior art peak detector(s) as a peak that triggers a switching event. Due to the switching event and possibly a resonating effect the piezoelectric voltage rises to a value of approximately +1V. However, as the piezoelectric element is currently excited in a manner that generates a negative piezoelectric voltage, the piezoelectric voltage decreases again to approximately -0.5V. The peak at +1V is again falsely detected by the prior art peak detector(s) and a further switching event is triggered. The piezoelectric voltage decreases rapidly to approximately -4V without overshoot and continues to approximately -4.5V where the true switching-event-relevant negative peak occurs. Note that the piezoelectric voltage also overshoots after a transition from negative to positive but that the peak detector does not falsely detect this as a switching-event-relevant peak.

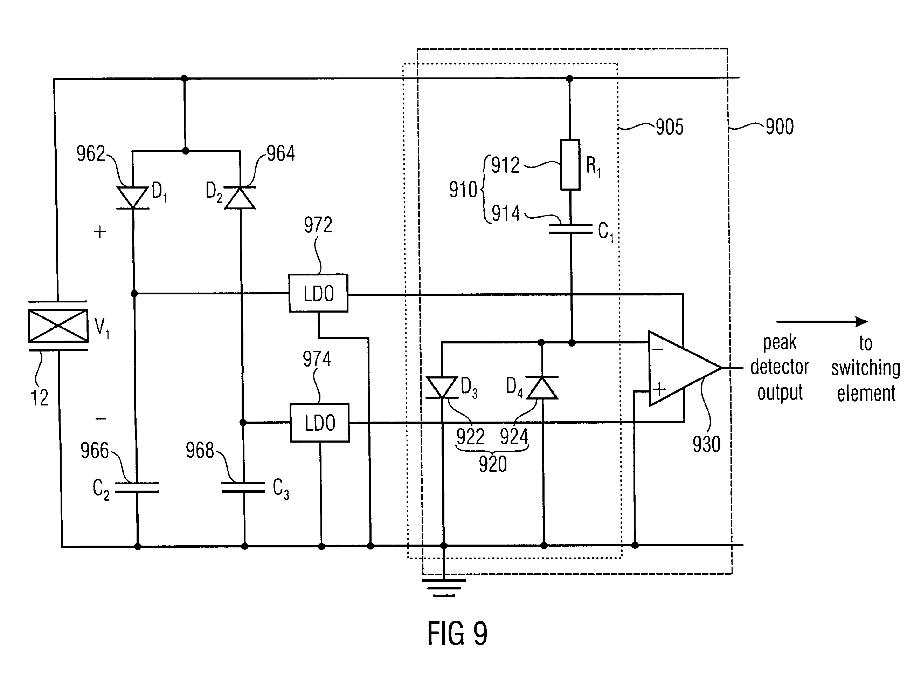

Taking into consideration the peak detector of Fig. 4, a new peak detector circuit is presented in Fig. 9. The peak detector is composed by a resistor $R_1$, a capacitor $C_1$, two diodes, $D_3$ and $D_4$, with an anti-parallel connection and a comparator. A capacitor $C_D$ in parallel with a resistor $R_D$ has been taken as equivalent model of the diodes. The transfer function of the proposed peak detector is:

$$\frac{V_{out}}{V_{in}} = \frac{s/(R_1 C_D)}{s^2 + s\left(\frac{1}{R_D C_D} + \frac{1}{R_1 C_1} + \frac{1}{R_1 C_D}\right) + \frac{1}{R_1 C_1 R_D C_D}}$$

This transfer function has a constant of $1/(R_1 C_D)$, a zero at the origin and a complex conjugate pole at

$$\omega_p = \sqrt{\frac{1}{R_1 C_1 R_D C_D}}.$$

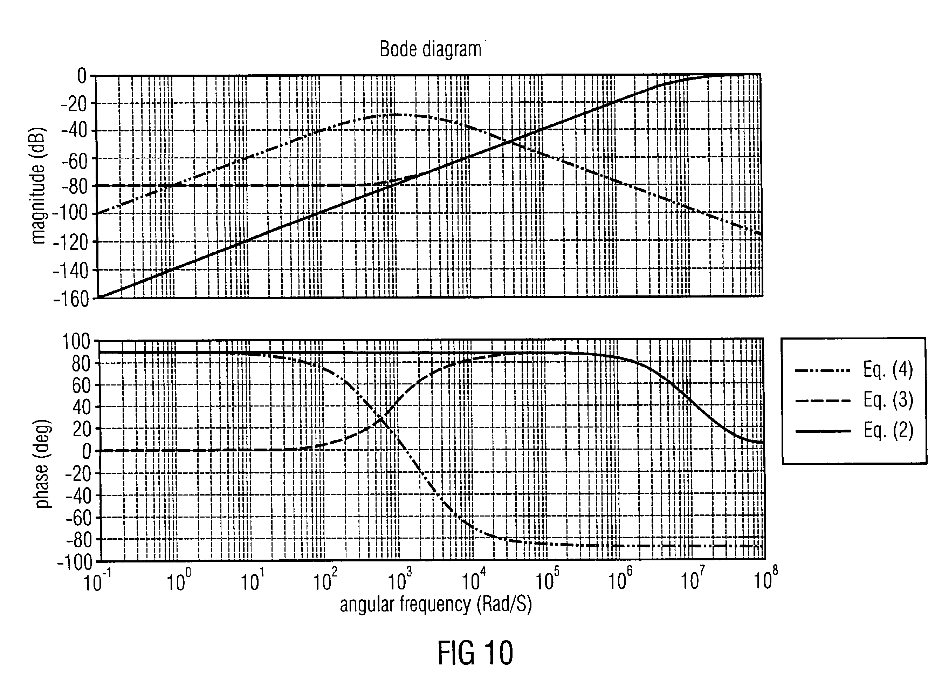

Fig. 10 shows the bode plot for the transfer functions of the peak detector illustrated in Fig. 4 without the hysteresis resistor $R_{hys}$ (thick solid line), of the peak detector illustrated in Fig. 4 with the hysteresis resistor $R_{hys}$ (dashed line), and of the peak detector according to the teachings disclosed herein and depicted in Fig. 9 (thin solid line). The corresponding transfer functions are:

| Fig. 4 without $R_{hys}$: $$\frac{V_{out}}{V_{in}} = \frac{s}{s + \frac{1}{R_{der} C_{der}}}$$ | thick solid line |
|---|---|
| Fig. 4 with $R_{hys}$: $$\frac{V_{out}}{V_{in}} = \frac{s + \frac{1}{R_{hys} C_{der}}}{s + \frac{R_{der} + R_{hys}}{R_{der} R_{hys} C_{der}}}$$ | dashed line |
| Fig. 9: $$\frac{V_{out}}{V_{in}} = \frac{s/(R_1 C_D)}{s^2 + s\left(\frac{1}{R_D C_D} + \frac{1}{R_1 C_1} + \frac{1}{R_1 C_D}\right) + \frac{1}{R_1 C_1 R_D C_D}}$$ | thin solid line |

The solution presented here as a peak detector circuit has a higher rejection to false peak detections when the piezoelectric voltage inversion is done before the peak displacement than the state-of-the art peak detector because it acts as a differentiator for low frequency signals and as an integrator for high frequency signals .

The bode plot of the peak detector depicted in Fig. 9 shows that it is (behaves as) a differentiator for low frequencies and an integrator at high frequencies. The bode plot of the peak detector according to Fig. 4 without the hysteresis resistor $R_{hys}$ is a first order high pass filter while the differentiator with hysteresis acts as a differentiator for a certain bandwidth. It becomes clear that the peak detectors depicted in Fig. 4 (without $R_{hys}$ and with $R_{hys}$) generate false detections for rapid peaks, i.e., peaks that have a significant high frequency components.

Going back to Fig. 9, the actual peak detector 900 according to the teachings disclosed herein comprises a filter 905 and a comparator 930. The comparator 930 comprises a first comparator input and a second comparator input, wherein the first comparator input is an inverting input and the second comparator input is a non-inverting input. The second comparator input is connected to an electrical mass potential. The first comparator input is connected to an output of the filter 905 and is configured to receive a filtered signal from the filter 905.

The filter comprises a first filter branch 910 and a second filter branch 920. The first filter branch extends between a first peak detector input terminal (connected to the "+"-terminal of the piezoelectric element 12) and the first comparator input terminal (inverting input). The first filter branch 910 comprises a series connection of the resistor $R_1$ and of the capacitor $C_1$. The capacitor $C_1$ is an energy storing element.

The second filter branch 920 extends between the first comparator input terminal (inverting input) and the electrical mass potential. The second filter branch 920 comprises two diodes 922 ($D_3$) and 924 ($D_4$) which are connected in an anti-parallel configuration. The two diodes form a clipper circuit. A clipper circuit is a device designed to prevent the output of a circuit from exceeding a predetermined voltage level. Depending on the threshold voltage(s) of the diodes 922 and 924, the voltage across the clipper circuit (i.e., from the first comparator input to the electrical mass potential) may assume any value within a voltage range that is delimited by clipping threshold(s) of the clipper threshold. The clipping threshold(s) may be identical to the threshold voltage(s) of the diodes 922, 924, or the clipping threshold may be a function (or functions) of thereof.

As described above, the anti-parallel configuration of the two diodes 922, 924 may be approximated by a parallel connection of the resistor $R_D$ and the capacitor $C_D$.

The peak detector 900 is connected to a power supply comprising two diodes 962 ($D_1$) and 964 ($D_2$), two capacitors 966 ($C_2$) and 968 ($C_3$), and two low-dropout regulators (LDO) 972 and 974. During a positive semi-cycle of the operation of the piezoelectric element 12, the capacitor 966 is charged via the diode 962. During a negative semi-cycle of the operation, the capacitor 968 is charged via the diode 964. The voltage across the capacitor 966 is provided as an input to the first LDO 972. Likewise, the voltage across the capacitor 968 is provided as an input to the second LDO 974. The first and second LDOs 972, 974 provide regulated power supply voltages to the comparator 930.

Briefly, the functionality of the peak detector 900 is as follows. When a positive (negative) peak voltage is reached on the piezoelectric element 12, the voltage on the inverting input of the comparator 930 changes its polarity from positive (negative) to negative (positive) acting as a differentiator. Since the voltage on the non-inverting input is higher (lower) than the voltage on the inverting input, the output voltage of the comparator 930 changes its value from -Vdd (+Vdd) to +Vdd (-Vdd).

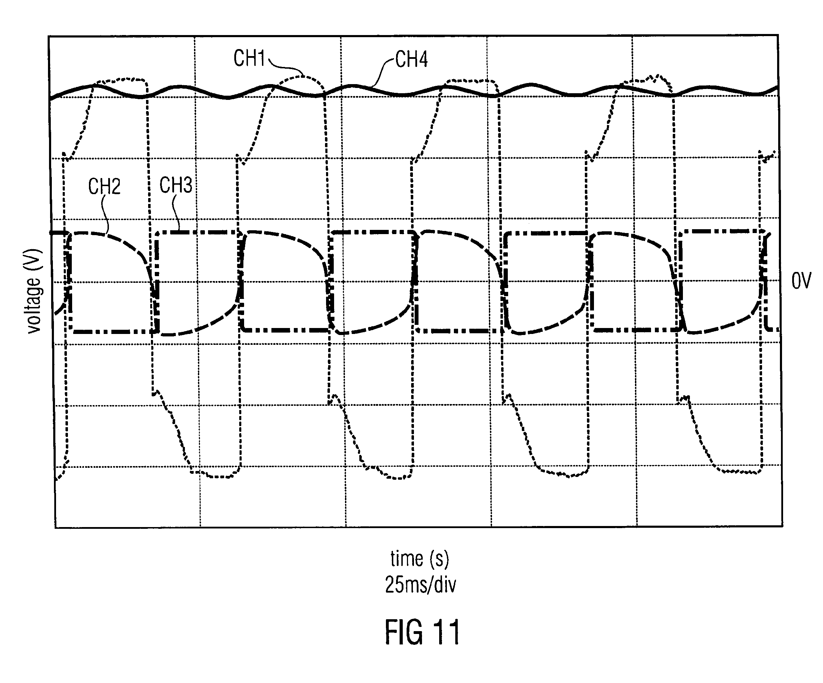

Fig. 11 shows steady state measured waveforms of the parallel SSHI circuit and its control circuit of Fig. 9. CH1 corresponds to the piezoelectric voltage, CH2 is the voltage on the negative input of the comparator 930 (voltage on the inverting input of the comparator 930), CH3 is the output voltage of the comparator 930 (control signal for the MOSFETs of an SSHI converter), and CH4 corresponds to the DC output voltage of the parallel SSHI converter. For all voltages the scale is 5V/division.

It can be seen that the voltage at the inverting input of the comparator 930 is not (or only negligibly) affected by the overshoots in the piezoelectric voltage which occur slightly after a transition of the piezoelectric voltage from negative to positive and from positive to negative. As a result, the comparator 930 switches (i.e., generates a rising edge or a falling edge) only after a "true" maximum/minimum has occurred (the maxima occur approximately at +16V and the minima occur approximately at -15.5V).

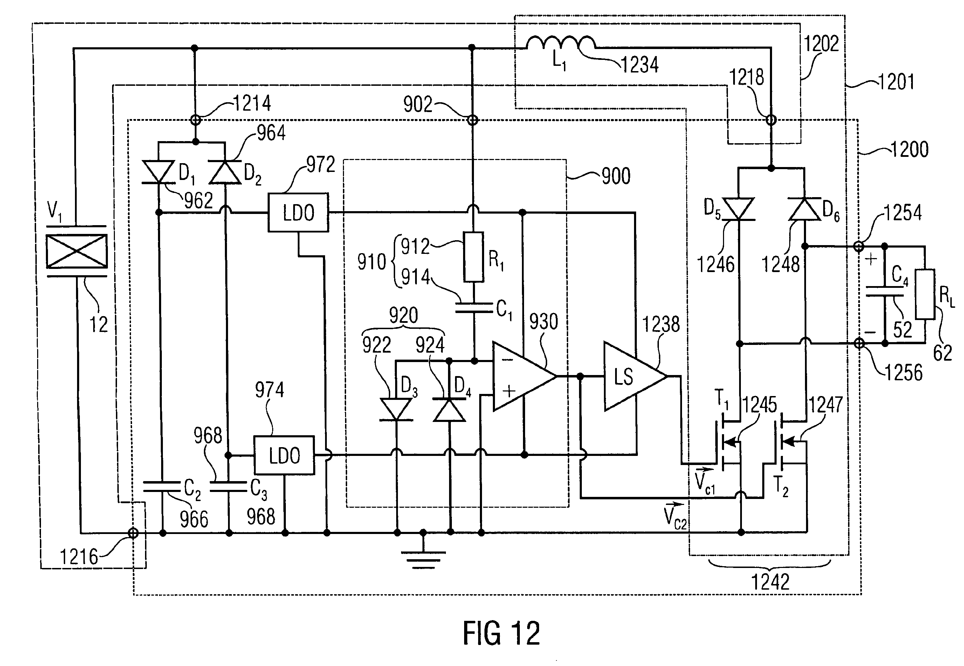

A peak detector according to the teachings disclosed herein may be used with a variety of AC-DC converters that have controllable switching elements and therefore require control signals for the controllable switching elements, such as a series SSHI converter, a parallel SSHI converter, or a synchronized rectifier (active rectifier). As an example, Fig. 12 shows a simplified schematic of a modified parallel SSHI converter 1200 comprising a peak detector 900 according to the teachings disclosed herein. The input voltage range of the modified parallel SSHI converter 1200 is ±20V.

The modified parallel SSHI converter 1200 is connected to a piezoelectric element 12 via AC side terminals 1216 and 1218 which are connected to a rectifier bridge 1242. The rectifier bridge 1242 of the modified parallel SSHI converter 1200 comprises a first bridge branch and a second bridge branch which are connected in a parallel configuration between the AC side terminals 1216 and 1218. The first bridge branch comprises a diode 1246 ($D_5$) and a n-channel MOSFET 1245 ($T_1$) of the enhancement type. The second bridge branch comprises a diode 1248 ($D_6$) and a n-channel MOSFET 1247 ($T_2$). A first DC-side terminal 1256 of the modified parallel SSHI converter 1200 is connected to a node between the diode 1246 ($D_5$) and the MOSFET 1245 ($T_1$) of the first bridge branch. A second DC-side terminal 1254 of the modified parallel SSHI converter 1200 is connected to a node between the diode 1248 ($D_6$) and the MOSFET 1247 ($T_2$) of the second bridge branch.

Both bridge branches comprise output nodes that are connected to one of the pairs of output terminals 1254, 1256. The output nodes are (electrically) between the controllable switching elements and the other switching elements (i.e., the diodes) of the bridge branches. Accordingly, the output node of the first bridge branch is connected to the output terminal 1256 and the output node of the second bridge terminal is connected to the output terminal 1254 of the parallel SSHI converter 1200 according to the embodiment of Fig. 12. A parallel circuit comprising the filter capacitor 52 and the output load 62 extends between the first output terminal 1256 and the second output terminal 1254.

The two n-channel MOSFETs 1245 and 1247 are controlled by two control signals $v_{C1}$ and $v_{C2}$, respectively. The gate of n-channel MOSFET 1245 is connected to an output of the peak detector 900 which provides the control signal $v_{C1}$. The gate of n-channel MOSFET 1247 is connected to an output of a positive level shifter 1238. An input of the positive level shifter 1238 is connected to the output of the peak detector 900 carrying the control signal $v_{C2}$. The positive level shifter 1238 processes the control signal $v_{C2}$ and produces the control signal $v_{C1}$ on the basis of $v_{C2}$. The control signals $v_{C1}$ and $v_{C2}$ control the n-channel MOSFETs 1245, 1247 in an alternating manner so that one of the n-channel MOSFETs 1245, 1247 is in a conducting state while the other MOSFET is in a non-conducting state.

The modified parallel SSHI converter 1200 may be implemented as an application specific integrated circuit (ASIC). The inductor 1234 is an external component of the ASIC. The following numbers are provided as an example, only, and should not be construed as limiting the scope of what is claimed in any way. The two linear regulators 972, 974 supply the comparator 930 that has a quiescent current of 800 nA at 5.2 V input. The positive linear regulator 972 provides 1.8 V at the output and has a quiescent current of 0.5 $\mu$A. The negative linear regulator 974 has an output voltage of -3.4 V and a quiescent current of 1.1 $\mu$A. Diodes $D_1$ and $D_2$ have a diode forward voltage of 1.8 V and a reverse voltage of 20 V. Diodes $D_3$ and $D_4$ have a diode forward voltage of 0.57 V and a reverse voltage of 20 V. Diodes $D_5$ and $D_6$ are synchronous diodes since the power losses on this stage would be significant if a diode is employed due to its voltage drop. Once the cathode voltage of one of the diodes $D_5$ and $D_6$ is higher than 1.8 V, the voltage drop on the synchronous diodes $D_5$ and $D_6$ is around 100 mV for a cathode voltage of 5 V and 300mV for a cathode voltage of 20 V. In alternative embodiments, the diodes 1246 ($D_5$) and 1248 ($D_6$) could be replaced with further controllable switching elements, e.g. MOSFETs.

A first partial circuit 1201 useful for understanding the operation of the modified parallel SSHI converter 1200 comprises the rectifier bridge 1242 and the inductor 1234 as an energy storing element. The two controllable switching elements 1245, 1247 of the rectifier bridge 1242 enable a low-ohmic connection (substantially a short-circuit) between the pair of input terminals 1216, 1218 to be formed via the first bridge branch or the second bridge branch. In this manner, a second partial circuit 1202 comprising the energy storing element 1234, the pair of input terminals 1216, 1218, and the energy source 12 (e.g., the piezoelectric element) may be substantially short-circuited and the energy storing element 1234 is connected in parallel to the energy source 12. Accordingly, the rectifier circuit 1200 may be regarded as a parallel SSHI converter. Note that the energy storing element 1234 is considered to be a part of the first partial circuit 1201 and also of the second partial circuit 1202. The grouping of several elements within the first partial circuit 1201 and the second partial circuit 1202 is done for explanatory purposes so that is becomes more readily clear, which components are affected by, for example, a substantial short-circuit caused by the rectifier bridge 1242.

The modified parallel SSHI topology according to the embodiment shown in Fig. 12 is just composed by two diodes 1246, 1248 and two MOSFETs 1245, 1247 which reduce the voltage drops of the diodes and MOSFETs with respect to some parallel and series SSHI circuits according to the prior art. Since two diodes of the rectifier bridge have been substituted by two active MOSFETs 1245, 1247, the power harvested by the modified parallel SSHI 1200 has increased in comparison with the other SSHI topologies. Moreover, no further diode or transistors are required which increases the efficiency as well. The use of the modified parallel SSHI topology not only harvests more power from the piezoelectric element but also broadens the frequency bandwidth of the converter 1200 compared with the other SSHI converter circuits.

The modified parallel SSHI converter 1200 typically has four different phases of operation, two of which are rectifying or rectification phases and the two other phases being inversion phases of the operation of the modified parallel SSHI converter 1200. A rectification phase is followed by an inversion phase, i.e., the rectification phases and the inversion phases follow an alternating pattern.

In a first rectification phase, the piezoelectric element 12 currently generates a piezoelectric voltage $v_1$ that is positive and greater (regarding the magnitude) than a rectified voltage at the filter capacitor 52 plus the voltage gap of one diode 1246 or 1248 and a possible voltage drop over a controllable switching element 1245 or 1247. The controllable switching element 1247 is controlled to be in a conducting state by the peak detector 900 and the control signal $v_{C2}$. This fact and the fact that the piezoelectric voltage $v_1$ is greater than the rectified voltage causes the diode 1246 ($D_5$) to become conductive so that a current path is formed, the current path starting from a first terminal of the piezoelectric element 12 via the energy storing element or inductor 1234, the first input terminal 1216, the diode 1246 ($D_5$), the filter capacitor 52 and the load 62, the controllable switching element 1247, and the second input terminal 1218 back to a second terminal of the piezoelectric element 12. The electrical current thus charges the filter capacitor 52.

When the piezoelectric voltage $v_1$ reaches its positive peak, diode 1246 ($D_5$) conducts and the control signal $v_{C2}$ changes its polarity. Thus, the MOSFET 1247 stops conducting (i.e., turns off) and the MOSFET 1245 starts conducting due to a corresponding polarity change of the control signal $v_{C1}$ generated by the positive level shifter 1238, thereby connecting the inductor 1234 in parallel to the piezoelectric element 12. During a second phase of the operation of the rectifier circuit 1200 an inversion of the piezoelectric voltage $v_1$ is performed. The inversion is made possible by the formation of a resonant circuit due to the parallel connection of the internal capacitance of the piezoelectric element 12 and the inductor 1234. In other words, during the second phase of the operation of the rectifier circuit 1200 a temporary conducting path via the rectifier bridge 1242 is formed along a bridge branch comprising the diode 1246 ($D_5$) and the MOSFET 1245 ($T_1$). The temporary conducting path substantially bypasses the pair of output terminals 1254, 1256 and substantially short-circuits the second circuit 1202 which comprises the energy storing element 1234 (i.e., the inductor), the pair of input terminals 1216, 1218, and the energy source 12 (i.e., the piezoelectric element) that is connectable to the pair of input terminals 1216, 1218.

Once the inversion is completed and the piezoelectric voltage $v_1$ reaches a negative peak value, diode 1246 ($D_5$) does not conduct anymore and the diode 1248 ($D_6$) starts conducting. During the rectification phase of the negative semi-cycle, $D_6$ and $T_1$ conduct.

A further phase of the operation of the rectifying circuit is an inversion phase of the negative semi-cycle. When the piezoelectric voltage $v_1$ reaches its negative peak, the peak detector 900 causes the control signal $v_{c2}$ to change its polarity from positive to negative. Thus, the MOSFET 1245 stops conducting and the MOSFET 1247 starts conducting again connecting the inductor 1234 in parallel to the piezoelectric element 12. During the inversion phase of the negative semi-cycle the bridge branch comprising the MOSFET 1247 ($T_2$) and the diode 1248 ($D_6$) form a temporary conducting path via the rectifier bridge 1242 which substantially bypasses the output terminals 654, 656 and which substantially short-circuits the second circuit 1202. Once the inversion is completed and the piezoelectric voltage $v_1$ reaches a positive value, diode 1246 ($D_5$) starts conducting and the cycle starts over again with the rectification phase of the positive semi-cycle. During the rectification phase of the positive semi-cycle, the diode 1246 ($D_5$) and the MOSFET 1247 ($T_2$) conduct.

The peak detector 900 is configured to sense the piezoelectric voltage $v_1$ and to generate the control signal $v_{C2}$ on the basis of the sensed piezoelectric voltage $v_1$. For example, the peak detector 900 may be configured to detect local maxima and local minima of the piezoelectric voltage $v_1$ and the control signal $v_{C2}$ may be switched from a positive level to a negative level upon detection of a local maximum or minimum, or vice versa. The positive level shifter 1238 further processes the control signal $v_{C2}$ to generate the control signal $v_{C1}$ for the MOSFET 1245.

During the rectification of the AC power, the modified parallel SSHI converter 1200 substantially acts as a half-synchronous rectifier since the circuit has two diodes 1246, 1248 and two MOSFETs 1245, 1247. Thus, the efficiency during this phase (these phases) is increased with respect to the other existing SSHI topologies. A synchronous rectification of the diodes is also possible employing the control circuit for synchronous rectification that appears in the European patent application 10192761.4 entitled "Diodenersatzschaltung, Aufwartswändlerschaltung, Abwärtswandlerschaltung und Brückengleichrichterschaltung" of the inventor M. Pollack. Moreover, if the two diode 1246 ($D_5$), 1248 ($D_6$) are substituted by two active MOSFETs, the efficiency may increase, in particular if the peak detector 900 consumes relatively little power. A synchronous rectifier may also be selected for the design of the application specific integrated circuit (ASIC) since diodes designed with, for example, some CMOS technologies may have a voltage drop of 1.8V for a continuous reverse voltage of 20 V. Discrete MOSFETs that may offer better efficiency results in SSHI converters are designed for high frequency applications although the vibration frequencies employed for exciting the piezoelectric elements are relatively low, e.g., below 110 Hz. The cause is that when the piezoelectric element is connected in parallel with the inductor through the MOSFET and the diode, a resonant LC circuit is established with a resonant frequency of $2\pi\sqrt{(LC)}$ and the low capacitances associated to high frequency transistors provide better results.

Besides the peak detector 900 the teachings disclosed herein thus also relate to a rectifier circuit or SSHI converter 1200 comprising a pair of input terminals 1216, 1218, a pair of output terminals 1254, 1256, and a first circuit 1201 interconnecting the pair of input terminals 1216, 1218. The first circuit 1201 comprises an energy storing element 1234 and a rectifier bridge 1242, wherein the rectifier bridge 1242 comprises at least one controllable switching element 1245, 1247 per bridge branch, wherein an output of the rectifier bridge 1242 supplies the pair of output terminals 1254, 1256 and wherein the at least one controllable switching element 1245, 1247 per bridge branch is configured to provide a temporary conducting path via the rectifier bridge 1242 which substantially bypasses the pair of output terminals 1254, 1256 and which substantially short-circuits a second circuit 1202 comprising the energy storing 1234 element, the pair of input terminals 1216, 1218, and an energy source 12 connectable to the pair of input terminals 1216, 1218. Furthermore, the SSHI converter may comprises a peak detector 900 according to the teachings disclosed herein.

According to further embodiments of the present invention, the energy storing element (or energy storage element) and the rectifier bridge may be connected in series.

The rectifier bridge 1242 may be configured to function both as an energy transferring component from the pair of input terminals 1216, 1218 to the pair of output terminals 1254, 1256 and as an inverter for the pair of input terminals.

Each bridge branch may comprise a diode component 1246, 1248 and the at least one controllable switching element 1245, 1247.

According to at least some further embodiment of the teachings disclosed herein, the rectifier circuit 1242 may further comprise a controller configured to generate at least one control signal for the at least one controllable switching element per bridge branch on the basis of a sense signal indicating a state of the energy source. In particular, the controller may be a peak detector 900 according to the teachings disclosed herein.

The controller may be configured to cause a switching of the at least one controllable switching element 1245, 1247 from a conducting state to a non-conducting state, or vice versa, upon a detection of a peak in the sense signal.

The energy storing element 1234 may form a resonant circuit with the energy source 12 while the second circuit 1202 is short-circuited via the rectifier bridge 1242.

According to at least some further embodiments of the teachings disclosed herein the energy storing element 1234 may be connectable in parallel to the energy source while the second circuit 1202 is short-circuited via the rectifier bridge 1242.

According to some further embodiments, the energy source 1 may be a piezoelectric element.

Further embodiments of the teachings disclosed herein provide a method for rectifying an electrical current generated by an energy source. The method comprises applying the electrical current to a first circuit comprising a rectifier bridge and an energy storing element so that the rectifier bridge conducts the electrical current to an output of the rectifier bridge along a first rectification path associated with a first current flow direction of the electrical current. The method further comprises detecting a first specific pattern in a sense signal associated with the electrical current and reconfiguring the rectifier bridge, in response to detecting the first specific pattern, by switching a controllable switching element of the rectifier bridge from a non-conducting state to a conducting state. In this manner, the electrical current is conducted within the rectifier bridge along a first inversion path that substantially short-circuits a second circuit comprising the energy storing element and the energy source and bypasses an output of the rectifier bridge. The rectifier bridge is then again reconfigured or allowed to perform a self-reconfiguration in response to a change of the current flow direction from the first current flow direction to a second current flow direction so that the rectifier bridge conducts the electrical current to the output of the rectifier bridge along a second rectification path associated with the second current flow direction.

The detection of the first pattern in the sense signal may be based on a method for detecting a peak in an electrical input voltage for an alternating-current/direct-current converter according to the teachings disclosed herein. The mentioned method for detecting the peak comprises receiving an input signal for a peak detector and filtering the input signal with a filter having differentiating transfer characteristic for a low frequency range and an integrating transfer characteristic for a high frequency range of the input signal, to obtain a filtered signal, so that peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal. The method for detecting further comprises comparing the filtered signal with a comparator threshold and generating an output signal on the basis of a result of comparing the filtered signal with the comparator threshold, the output signal indicating a relation of the filtered signal with respect to the comparator threshold.

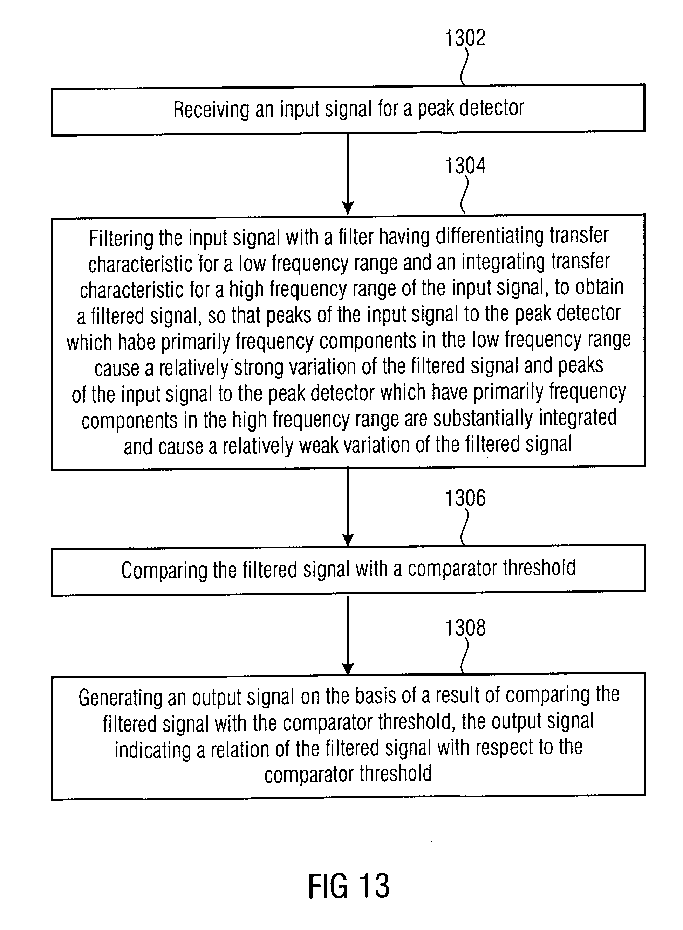

Fig. 13 shows a schematic flow diagram of a method for detecting a peak in an electrical input voltage for an alternating-current/direct-current (AC-DC) converter. At a step 1302 an input signal for a peak detector is received. At a step 1304 the input signal is filtered with a filter having a differentiating transfer characteristic for a low frequency range and an integrating transfer characteristic for a high frequency range of the input signal. In this manner a filtered signal may be obtained. Peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal.

At a step 1306 of the method illustrated in Fig. 13 the filtered signal is compared with a comparator threshold. At a step 1308 an output signal is generated on the basis of a result of comparing the filtered signal with the comparator threshold, the output signal indicating a relation of the filtered signal with respect to the comparator threshold.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, some one or more of the most important method steps may be executed by such an apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. Peak detector (900) for a synchronized switch harvesting on inductor converter, the peak detector comprising a comparator (930);

a filter (905) configured to filter an input signal to the peak detector and to provide a filtered signal to an input of the comparator (930), wherein the filter has a differentiating transfer characteristic for a low frequency range and an integrating transfer characteristic for a high frequency range of the input signal so that peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal;

wherein the relatively strong variation of the filtered signal crosses a comparator threshold of the comparator (930) and wherein the comparator (930) is configured to generate an output signal that indicates a relation of the filtered signal with respect to the comparator threshold.

2. Peak detector (900) according to claim 1, wherein a magnitude transfer function of the filter has a maximum at a frequency between the low frequency range and the high frequency range.

3. Peak detector (900) according to claim 1 or 2, wherein a maximum magnitude frequency of a transfer function of the filter is between 80Hz and 400Hz.

4. Peak detector (900) according to any one of the preceding claims, wherein the filter (905) comprises a first filter branch connected between a first peak detector input terminal and a comparator input terminal, and a second filter branch connected between a second peak detector input terminal and the comparator input terminal, wherein at least one of the first filter branch and the second filter branch comprises an energy storing element (914).

5. Peak detector (900) according to any one of the preceding claims, wherein the filter (905) comprises a voltage divider configured to divide an input voltage corresponding to the input signal and to provide a divisional voltage at an intermediary node on the basis of which the filtered signal is determined.

6. Peak detector (900) according to any one of the preceding claims, wherein the filter (905) comprises at least one linear component (912, 914) and at least one non-linear component (922, 924).

7. Peak detector (900) according to any one of the preceding claims, wherein the filter (905) comprises
an energy storing circuit (910) connecting a first input of the peak detector to a first input of the comparator (930), the energy storing circuit (910) exhibiting an energy storing behavior; and
a clipper circuit (920) connecting a second input of the peak detector to the first input of the comparator (930), the clipper circuit (920) being configured to maintain a clipper circuit voltage across the clipper circuit within a voltage range defined by at least one clipping threshold and being configured to maintain the clipper circuit voltage at the clipping threshold while an input voltage between the first input and the second input of the peak detector is monotone and outside the voltage range;
wherein a comparator input voltage between the first input of the comparator and a second input of the comparator (930) is based on the clipper circuit voltage, a comparator threshold voltage of the comparator being within the voltage range;
wherein the energy storing circuit (910) is configured, due to the energy storing behavior, to push the clipper circuit voltage across the clipping threshold into the voltage range and thereby causes the comparator input voltage to cross the comparator threshold in response to a peak in the input voltage so that an output of the comparator (930) indicates the peak as a signal edge.

8. Peak detector (900) according to claim 7, wherein the energy storing circuit (910) comprises a capacitor (914) and a resistor (912), the capacitor (914) being configured to provide the energy storing behavior by storing an electrical charge.

9. Peak detector (900) according to claim 8, wherein in response to the peak a capacitor voltage across the capacitor (914) changes relatively slowly so that the voltage at the first input of the comparator (930) substantially follows the peak which causes the clipper circuit voltage to be pushed away from the clipping threshold into the voltage range of the clipper circuit (920).

10. Peak detector according to any one of claims 7 to 9, wherein the clipper circuit (920) is configured to be in a blocking state when the clipper circuit voltage is not at the clipping voltage and to be in a non-blocking state when the clipper circuit voltage is at or beyond the clipping voltage.

**11.** Peak detector (900) according to any one of claims 7 to 10, wherein the clipper circuit (920) comprises two antiparallel diodes (922, 924) or two antiparallel elements with diode-like characteristic.

**12.** Peak detector (900) according to any one of claims 7 to 11, wherein the clipping threshold is an upper clipping threshold and wherein the voltage range is further defined by a lower clipping threshold;
wherein the clipper circuit (920) is configured to maintain the clipper circuit voltage at the lower clipping threshold when the input voltage between the first input and the second input of the peak detector is below the lower threshold and monotonously diverging from the lower threshold; and
wherein the clipper circuit (920) is further configured to maintain the clipper circuit voltage at the upper clipping threshold when the input voltage between the first input and the second input of the peak detector is above the upper threshold and monotonously diverging from the upper threshold.

**13.** Converter (1200) for converting alternating current to direct current, the converter comprising a peak detector (900) according to any one of the preceding claims.

**14.** Method for detecting a peak in an electrical input voltage for an alternatingcurrent/direct-current converter, the method comprising:

receiving an input signal for a peak detector;
filtering the input signal with a filter having differentiating transfer characteristic for a low frequency range and an integrating transfer characteristic for a high frequency range of the input signal, to obtain a filtered signal, so that peaks of the input signal to the peak detector which have primarily frequency components in the low frequency range cause a relatively strong variation of the filtered signal and peaks of the input signal to the peak detector which have primarily frequency components in the high frequency range are substantially integrated and cause a relatively weak variation of the filtered signal;
comparing the filtered signal with a comparator threshold;
generating an output signal on the basis of a result of comparing the filtered signal with the comparator threshold, the output signal indicating a relation of the filtered signal with respect to the comparator threshold.

**15.** Method for generating a control signal for at least one controllable switching element of an alternating-current/direct-current converter, the method comprising:

detecting a peak in an electrical input voltage for the alternating-current/direct-current converter according to the method of claim 14; and
generating the control signal on the basis of the output signal of the method for detecting the peak.

FIG 1A

FIG 1B

FIG 2A

| | U |
|---|---|
| | $V_1$ |
| | $V_L$ |

| | $i_P$ |
|---|---|
| | $i_S$ |

FIG 2B

FIG 3

FIG 4

FIG 5A

FIG 5B

piezoelectric harvested power (W)

time (s)

I(V1)*(V(piezo+) – V(piezo–))

3.0E-03  2.5E-03  2.0E-03  1.5E-03  1.0E-03  5.0E-04  0  -5.0E-04

1.2E-01  1.25E-01  1.3E-01  1.35E-01  1.4E-01

FIG 6A

FIG 6B

FIG 7A

FIG 7B

FIG 8

FIG 9

EP 2 579 445 A1

Bode diagram

FIG 10

EP 2 579 445 A1

time (s)
25ms/div

FIG 11

EP 2 579 445 A1

FIG 12

EP 2 579 445 A1

1302

Receiving an input signal for a peak detector

1304

Filtering the input signal with a filter having differentiating transfer characteristic for a low frequency range and an integrating transfer characteristic for a high frequency range of the input signal, to obtain a filtered signal, so that peaks of the input signal to the peak detector which habe primarily frequency components in the low frequency range cause a relatively strong variation of the filtered signal and peaks of the input signal to the peak detector which have primarily frequency components in the high frequency range are substantially integrated and cause a relatively weak variation of the filtered signal

1306

Comparing the filtered signal with a comparator threshold

1308

Generating an output signal on the basis of a result of comparing the filtered signal with the comparator threshold, the output signal indicating a relation of the filtered signal with respect to the comparator threshold

FIG 13

Europäisches
Patentamt
European
Patent Office
Office européen
des brevets

# EUROPEAN SEARCH REPORT

Application Number

EP 11 18 4378

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 195 34 464 C1 (ROWENTA WERKE GMBH [DE]) 5 December 1996 (1996-12-05) | 1-6,14 | INV. H02N2/18 |
| Y | * column 2, lines 14-35; figures 1, 3 * | 7,8, 10-13,15 | H03K17/30 G01R19/00 H02M7/219 |
| Y | US 2005/258855 A1 (KIMURA HIROKI [JP]) 24 November 2005 (2005-11-24) * paragraph [0042]; figure 4 * | 7,8, 10-12 | ADD. G01R19/04 |
| Y,D | BEN-YAAKOV S ET AL: "Resonant rectifier for piezoelectric sources", APPLIED POWER ELECTRONICS CONFERENCE AND EXPOSITION, 2005. APEC 2005. TWENTIETH ANNUAL IEEE AUSTIN, TX, USA 6-10 MARCH 2005, PISCATAWAY, NJ, USA,IEEE, US, vol. 1, 6 March 2005 (2005-03-06), pages 249-253VOL.1, XP010809405, DOI: 10.1109/APEC.2005.1452928 ISBN: 978-0-7803-8975-5 * page 250, right-hand column, paragraph 2 - page 251, right-hand column, paragraph 2 * * page 253, right-hand column, paragraph 2; figures 4,9 * | 13,15 | |
| X | GB 888 692 A (IBM) 31 January 1962 (1962-01-31) * figure 1 * | 1,14 | TECHNICAL FIELDS SEARCHED (IPC) H02N H03K G01R H02M |
| A | US 2004/239373 A1 (SESHITA TOSHIKI [JP]) 2 December 2004 (2004-12-02) * abstract; figures 1,2 * | 1,13,14 | |
| A | US 2011/227543 A1 (IVANOV VADIM V [US]) 22 September 2011 (2011-09-22) * abstract; figures 1-4 * | 13 | |

-/--

The present search report has been drawn up for all claims

| Place of search | Date of completion of the search | Examiner |
|---|---|---|
| Munich | 3 April 2012 | Iwansson, Kaj |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 11 18 4378

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 59 221814 A (MAITETSUKU KK) 13 December 1984 (1984-12-13) * abstract; figures 2,3 * ----- | 1,7 | |
| A,D | MICKAÃ L LALLART ET AL: "An optimized self-powered switching circuit for non-linear energy harvesting with low voltage output", SMART MATERIALS AND STRUCTURES, IOP PUBLISHING LTD., BRISTOL, GB, vol. 17, no. 3, 1 June 2008 (2008-06-01), page 35030, XP020137054, ISSN: 0964-1726 * page 5, right-hand column, paragraphs 2, 3; figures 3b, 6a, 6b * ----- | 1,13-15 | |
| | | | **TECHNICAL FIELDS SEARCHED (IPC)** |

The present search report has been drawn up for all claims

| Place of search | Date of completion of the search | Examiner |
|---|---|---|
| Munich | 3 April 2012 | Iwansson, Kaj |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 18 4378

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2012

| Patent document cited in search report | | Publication date | Patent family member(s) | | Publication date |
|---|---|---|---|---|---|
| DE 19534464 | C1 | 05-12-1996 | NONE | | |
| US 2005258855 | A1 | 24-11-2005 | CN | 1954226 A | 25-04-2007 |
| | | | DE | 112005001161 T5 | 28-06-2007 |
| | | | KR | 20070026596 A | 08-03-2007 |
| | | | US | 2005258855 A1 | 24-11-2005 |
| | | | WO | 2005111639 A1 | 24-11-2005 |
| GB 888692 | A | 31-01-1962 | DE | 1161058 B | 09-01-1964 |
| | | | FR | 1222550 A | 10-06-1960 |
| | | | GB | 888692 A | 31-01-1962 |
| | | | US | 2961642 A | 22-11-1960 |
| US 2004239373 | A1 | 02-12-2004 | CN | 1574523 A | 02-02-2005 |
| | | | JP | 3751955 B2 | 08-03-2006 |
| | | | JP | 2004356329 A | 16-12-2004 |
| | | | US | 2004239373 A1 | 02-12-2004 |
| US 2011227543 | A1 | 22-09-2011 | US | 2011227543 A1 | 22-09-2011 |
| | | | WO | 2011115652 A1 | 22-09-2011 |
| JP 59221814 | A | 13-12-1984 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- FR 2005003000 W
- WO 2007063194 A
- EP 10192761 A

### Non-patent literature cited in the description

- **S. PRIYA ; D.J. INMAN.** Energy Harvesting Technologies. Springer, 2009, 209-259
- **M. LALLART ; D. GUYOMAR.** An optimized self-powered switching circuit for non-linear energy harvesting with low voltage output. *Smart Materials and Structures,* 2008, vol. 17 (3
- **S. BEN-YAAKOV ; N. KRIHELY.** Resonant rectifier for piezoelectric sources. *Applied Power Electronics Conference and Exposition, 2005, APEC 2005, Twentieth Annual IEEE,* 06 March 2005, vol. 1, 249-253
- **D. GUYOMAR ; G. SEBALD ; S. PRUVOST ; M. LALLART ; A. KHODAYARI ; C. RICHARD.** Energy Harvesting from Ambient Vibrations and Heat. *Journal of Intelligent Material Systems and Structures,* March 2009, vol. 20 (5), 609-624
- **S. BEN-YAAKOV ; N. KRIHELY.** Resonant rectifier for piezoelectric sources. *Applied Power Electronics Conference and Exposition, 2005. APEC 2005,* 06 March 2005, vol. 1, 249-253
- **S. PRIYA ; D.J. INMAN.** Energy Harvesting Technologies. Springer, 2009, 211-213